**Europäisches Patentamt**

**European Patent Office**

**Office européen des brevets**

(19)

(11) Veröffentlichungsnummer: **0 198 224**
**B1**

(12)

# EUROPÄISCHE PATENTSCHRIFT

(45) Veröffentlichungstag der Patentschrift:
**19.07.89**

(51) Int. Cl.⁴: **H05K 5/02**

(21) Anmeldenummer: **86103376.9**

(22) Anmeldetag: **13.03.86**

(54) Gehäuse.

(30) Priorität: **17.04.85 DE 8511254 U**

(43) Veröffentlichungstag der Anmeldung:
**22.10.86 Patentblatt 86/43**

(45) Bekanntmachung des Hinweises auf die Patenterteilung:
**19.07.89 Patentblatt 89/29**

(84) Benannte Vertragsstaaten:
**BE CH DE FR GB IT LI LU NL SE**

(56) Entgegenhaltungen:
**DE-U- 7 523 895**
**DE-U- 7 621 235**
**FR-A- 2 289 402**
**US-A- 2 935 554**

(73) Patentinhaber: **bopla Gehäuse Systeme GmbH,**
**Uhlendieckstrasse 134-140, D-4980 Bünde(DE)**

(72) Erfinder: **Frankowski, Günter, Meyerstrasse 5,**
**D-4980 Bünde 1(DE)**

(74) Vertreter: **Patentanwälte Dipl.-Ing. Bodo Thielking**
**Dipl.-Ing. Otto Elbertzhagen, Gadderbaumer Strasse 20,**
**D-4800 Bielefeld 1(DE)**

## Beschreibung

Die Erfindung betrifft ein Gehäuse aus Kunststoff zur Aufnahme elektrischer, elektronischer, pneumatischer oder hydraulischer Bauelemente und Baugruppen, mit einer schwenkbar angelenkten Klappe, die in einer mit der Gehäuseaußenfläche zumindest im wesentlichen bündigen Stellung verriegelbar ist.

Ein Gehäuse dieser Art ist bekannt aus DE-U 7 523 895. Bei dem bekannten Gehäuse dient die Klappe als Abdeckung für dahinter angeordnete Bedienungselemente oder Anschlußbuchsen. Die bekannte Klappe ist als zweiarmiger Hebel ausgebildet. Zum Öffnen der Klappe muß das eine Ende der Klappe gedrückt und damit die Klappe in die Öffnungslage verschwenkt werden. Hierzu muß ein mit der Klappe verbundener Ansatz über eine Rastfeder verschoben werden. Die vorgesehene Feder dient ausschließlich zur Verrastung der Klappe in deren Schließstellung.

Bei Gehäusen zur Aufnahme elektrischer, elektronischer, pneumatischer oder hydraulischer Bauelemente und Baugruppen bilden die üblicherweise vorgesehenen Stellfüße störende Konturen.

Der Erfindung liegt deshalb die Aufgabe zugrunde, ein Gehäuse der als bekannt vorausgesetzten Art so auszubilden, daß es eine glattflächige Außenhautgestaltung ohne störende Vorsprünge zuläßt und besonders bedienungsfreundlich ist.

Die Lösung dieser Aufgabe erfolgt dadurch, daß die Klappe mittels einer Feder ausschwenkbar und mittels einer Drucktaste zum Ausschwenken entriegelbar ist und daß die Klappe einen Standfuß des Gehäuses bildet.

Es hat sich als zweckmäßig erwiesen, daß die Klappe rutschfeste Bereiche aufweist.

Bei einer bevorzugten Ausführungsform ist die Feder eine Schenkelfeder.

Ferner hat es sich als zweckmäßig erwiesen, daß die Drucktaste quer zur Schwenkachse der Klappe gegen die Kraft einer Rückstellfeder verstellbar ist.

Vorzugsweise sind die Drucktaste und die Klappe im Bereich von Seitenkanten des Gehäuses angeordnet.

Weitere bevorzugte Ausführungsformen sind in den weiteren Unteransprüchen beschrieben.

Nachstehend wird eine bevorzugte Ausführungsform der Erfindung anhand der Zeichnung im einzelnen beschrieben.

Es zeigen:

Figur 1 – eine perspektivische Gesamtansicht des erfindungsgemäßen Gehäuses,
Figur 2 – eine Explosionsdarstellung einer als Standfuß ausgebildeten Klappe mit dem zugehörigen Bereich des Gehäuses.

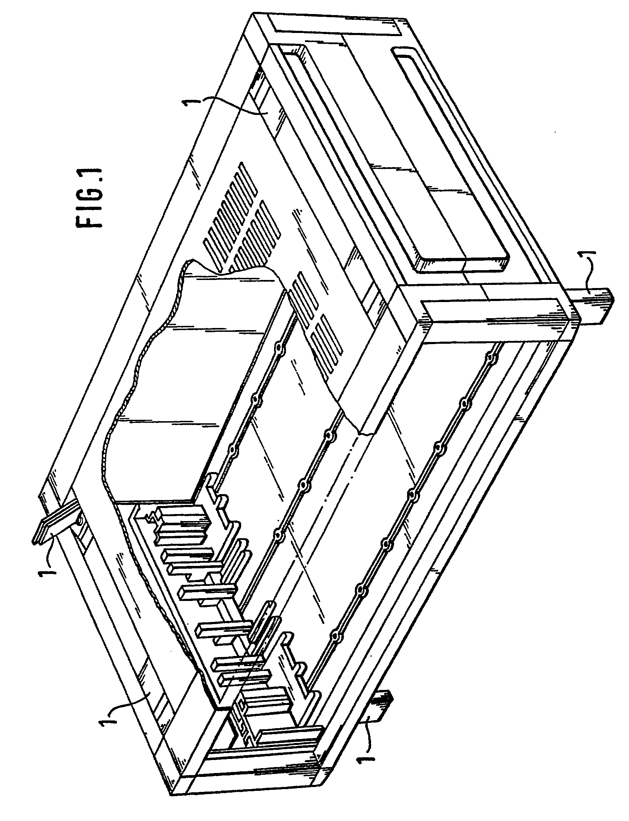

In dem in Figur 1 in perspektivischer Ansicht dargestellten Gehäuse sind sowohl auf der Oberseite als auch auf der Unterseite jeweils vier Klappen 1 vorgesehen. Im oberen Bereich sind die Klappen Abdeckklappen für darunterliegende Verbindungsschrauben zur Verbindung der beiden Gehäusehälften. Im unteren Bereich sind die Klappen 1 als

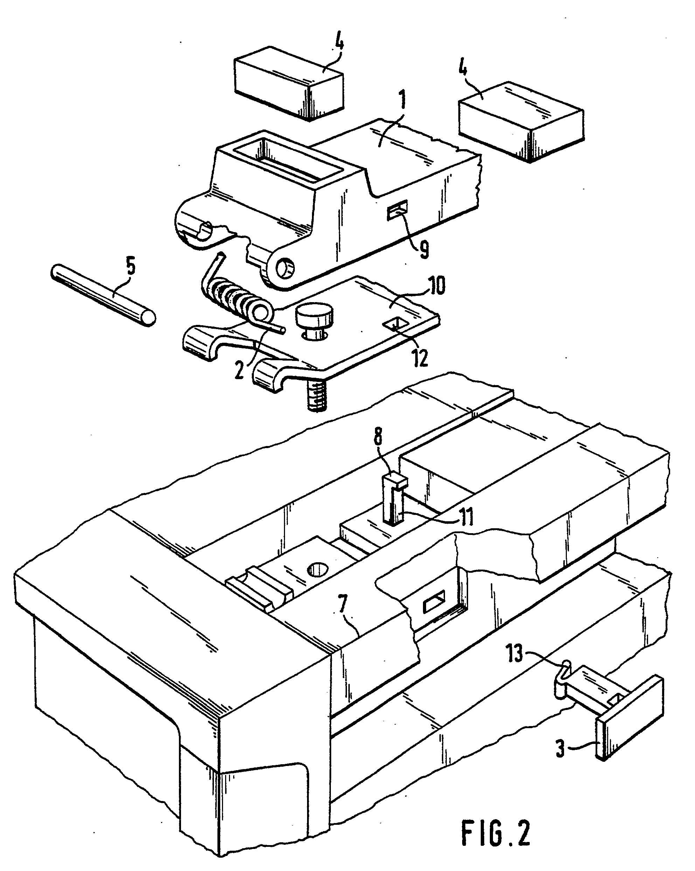

Standfüße ausgebildet. Sie weisen die in Figur 2 dargestellten rutschfesten Bereiche auf.

Die Standfüße sind um eine Schwenkachse 5 schwenkbar gelagert. Die Schwenkachse wird von einer Lasche 10 zur Bildung eines Scharniers übergriffen. Die Schwenkachse 5 ist von einer Schenkelfeder 2 umschlossen. Die Schenkelfeder 2 versucht, den Stellfuß in die Ausschwenklage zu drücken.

Seitlich am Gehäuse ist eine Drucktaste 3 vorgesehen, die an einem Bereich 11 eine Verriegelungsnase 8 aufweist. Die Verriegelungsnase 8 durchgreift die Ausnehmung 12 und ist zum Eingreifen in eine Ausnehmung 9 der Klappe 1 ausgebildet. Ein angeformter federnd elastischer Bereich 13 der Drucktaste drückt diese in die Ausgangslage zurück. Beim Eindrücken der Drucktaste rastet die Verriegelungsnase 8 aus der Ausnehmung 9 der Klappe 1 aus und die Klappe 1 kann unter der Einwirkung der Schenkelfeder 2 gemäß Figur 2 nach oben ausschwenken.

## Patentansprüche

1. Gehäuse aus Kunststoff zur Aufnahme elektrischer, elektronischer, pneumatischer oder hydraulischer Bauelemente und Baugruppen, mit einer schwenkbar angelenkten Klappe, die in einer mit der Gehäuseaußenfläche zumindest im wesentlichen bündigen Stellung verriegelbar ist, dadurch gekennzeichnet, daß die Klappe mittels einer Feder (2) ausschwenkbar und mittels einer Drucktaste (3) zum Ausschwenken entriegelbar ist und daß die Klappe (1) einen Standfuß des Gehäuses bildet.

2. Gehäuse nach Anspruch 2, dadurch gekennzeichnet, daß die Klappe (1) rutschfeste Bereiche (4) aufweist.

3. Gehäuse nach Anspruch 1 oder 2, dadurch gekennzeichnet, daß die Feder (2) eine Schenkelfeder ist.

4. Gehäuse nach einem oder mehreren der Ansprüche 1 bis 3, dadurch gekennzeichnet, daß die Drucktaste (3) quer zur Schwenkachse (5) der Klappe (1) gegen die Kraft einer Rückstellfeder (6) verschiebbar ist.

5. Gehäuse nach einem oder mehreren der Ansprüche 1 bis 4, dadurch gekennzeichnet, daß die Drucktaste (3) und die Klappe (1) im Bereich von Seitenkanten (7) des Gehäuses angeordnet sind.

6. Gehäuse nach einem oder mehreren der Ansprüche 1 bis 5, dadurch gekennzeichnet, daß die Drucktaste (3) eine Verriegelungsnase (8) zum Eingriff in eine Ausnehmung (9) der Klappe (1) aufweist.

7. Gehäuse nach einem oder mehreren der Ansprüche 1 bis 6, dadurch gekennzeichnet, daß die Rückstellfeder (6) der Drucktaste (3) durch einen angeformten federnd elastischen Bereich gebildet ist.

8. Gehäuse nach einem oder mehreren der Ansprüche 1 bis 7, dadurch gekennzeichnet, daß unter der Klappe (1) eine Verbindungsschraube für unterschiedliche Gehäuseteile vorgesehen ist.

## Claims

1. Plastic housing for receiving electrical, electronic, pneumatic or hydraulic components and subassemblies, with a pivotably articulated flap which is lockable in a position at least substantially flush with the outer face of the housing, characterized in that the flap can swing out by means of a spring (2) and is releasable for swinging out by means of a pushbutton (3), and in that the flap (1) forms a standing foot for the housing.

2. Housing according to Claim 1, characterized in that the flap (1) has non-slip regions (4).

3. Housing according to Claim 1 or 2, characterized in that the spring (2) is a leg spring.

4. Housing according to one or more of Claims 1 to 3, characterized in that the pushbutton (3) is shiftable transversely relative to the pivot pin (5) of the flap (1) counter to the force of a restoring spring (6).

5. Housing according to one or more of Claims 1 to 4, characterized in that the pushbutton (3) and the flap (1) are arranged in the region of side edges (7) of the housing.

6. Housing according to one or more of Claims 1 to 5, characterized in that the pushbutton (3) has a locking nose (8) for engagement into a recess (9) of the flap (1).

7. Housing according to one or more of Claims 1 to 6, characterized in that the restoring spring (6) of the pushbutton (3) is formed by a resiliently elastic formed-on region.

8. Housing according to one or more of Claims 1 to 7, characterized in that a connecting screw for different housing parts is provided under the flap (1).

## Revendications

1. Boîtier en matière plastique destiné à recevoir des éléments et ensembles de pièces détachées électriques, électroniques, pneumatiques ou hydrauliques, pourvu d'un volet articulé, pivotant, verrouillable dans une position dans laquelle il affleure, au moins en majeure partie, la surface extérieure du boîtier, caractérisé par le fait que le volet peut être pivoté à l'aide d'un ressort (2) et déverrouillé aux fins de pivotement à l'aide d'un bouton-poussoir (3), et que le volet 1 forme un pied du boîtier.

2. Boîtier selon revendication 1, caractérisé par le fait que le volet (1) présente des zones antidérapantes (4).

3. Boîtier selon revendication 1 ou 2, caractérisé par le fait que le ressort (2) est un ressort à branches.

4. Boîtier selon une ou plusieurs revendications 1 à 3 caractérisé par le fait que le bouton-poussoir (3) peut être poussé transversalement par rapport à l'axe de pivotement (5) du volet (1) en agissant contre la force d'un ressort de rappel (6).

5. Boîtier selon une ou plusieurs revendications 1 à 4, caractérisé par le fait que le bouton-poussoir (3) et le volet (1) sont disposés dans le secteur de bords latéraux (7) du boîtier.

6. Boîtier selon une ou plusieurs revendications 1 à 5, caractérisé par le fait que le bouton-poussoir (3) présente un taquet de verrouillage (8) s'enclenchant dans une cavité (9) du volet (1).

7. Boîtier selon une ou plusieurs revendications 1 à 6, caractérisé par le fait que le ressort de rappel (6) du bouton-poussoir (3) est formé par un secteur façonné élastique faisant ressort.

8. Boîtier selon une ou plusieurs revendications 1 à 7, caractérisé par le fait qu'une vis de raccordement pour différentes pièces du boîtier est prévue sous le volet (1).

FIG.1

FIG.2